# EUROPÄISCHE PATENTSCHRIFT

(11) **EP 2 099 270 B1**
(45) Veröffentlichungstag und Bekanntmachung des Hinweises auf die Patenterteilung: **15.06.2016**
(21) Anmeldenummer: 09002999.2
(22) Anmeldetag: 03.03.2009
(51) Int. Cl.: H04B 10/114, G01D 4/00, G01F 15/075, G01F 15/14, G01D 11/24, G01D 21/00, G01F 15/06, H05K 5/06

(54) **Gehäuse für einen kabellosen Kommunikationsport**
Housing for a wireless communication port
Boîtier pour un port de communication sans fil

(30) Priorität: 03.03.2008 DE 202008003012 U
(43) Veröffentlichungstag der Anmeldung: 09.09.2009
(73) Patentinhaber: APATOR S.A., 87-100 Torun (PL)
(72) Erfinder: Sztachelski, Michal, PL- 87-100 Torun (PL)
(74) Vertreter: Bischof, Oliver

(56) Entgegenhaltungen:
- DE-A1- 10 061 862
- DE-A1- 10 136 409
- US-A- 4 491 792
- US-A- 4 491 793
- US-A1- 2002 070 040
- US-A1- 2006 096 774
- US-A1- 2006 256 510
- US-A1- 2007 059 979
- US-A1- 2007 157 457

## Beschreibung

Die Erfindung betrifft ein Gehäuse für einen kabellosen, von einer Person mitführbaren optoelektronischen Kommunikationsport, mit einem Unterteil und einem Deckel, die die Wand des Gehäuses bilden und über einen staub- und wasserdichten Verschluss miteinander lösbar verrastet sind, wobei die Gehäusewand mit wenigstens einem lichtdurchlässigen Bereich versehen ist.

Der Kommunikationsport ist insbesondere zur Kommunikation mit einem Elektrizitätszähler bestimmt. Er ermöglicht eine schnelle und problemlose Datenübertragung, ohne dabei zusätzliche Leitungen, Geräte oder Software verwenden zu müssen. Der Kommunikationsport kann die Informationen in elektronischer Form aufbewahren und in beide Richtungen senden. Die ferngesteuerte Kommunikation mit dem Elektrizitätszähler ermöglicht das Ablesen und Monitoring sowohl durch den Energielieferanten als auch durch den Energieabnehmer.

Im Allgemeinen sind solche Methoden der Kommunikation mit Geräten bekannt, wie: Opto-Interface gemäß IEC 1107, paralleler Port RS232, RS485, ModBus, M-Bus, Lonworks, ProfiBus, Datenaustausch-Standard zwischen Automatiksystemen OPC, Ethernet/IP, Funkkommunikation 433 MHz, Kommunikation über Power-Line-Carrier-Netz sowie kabellose Technologie der Paketdatenübertragung GPRS. Die besagten Methoden sind kompliziert und erfordern die Anwendung von kostspieliger Ausstattung, zusätzlichen Vorrichtungen, Servern, Netzen, Terminals, Leitungen und Verbindungen.

Ein Gehäuse der im Oberbegriff beschriebenen Art lässt sich der DE 102 36 409 A1 entnehmen. Nachteilig ist, dass für das Gehäuse keine Positionierungsmöglichkeiten am Sender, insbesondere keine Magnetelemente, gegebenenfalls am Zähler vorgesehen sind. Vielmehr ist das Gehäuse für Anwendungen in der Unterhaltungselektronik, vor allem für den Einbau in den Kopfhörer konzipiert.

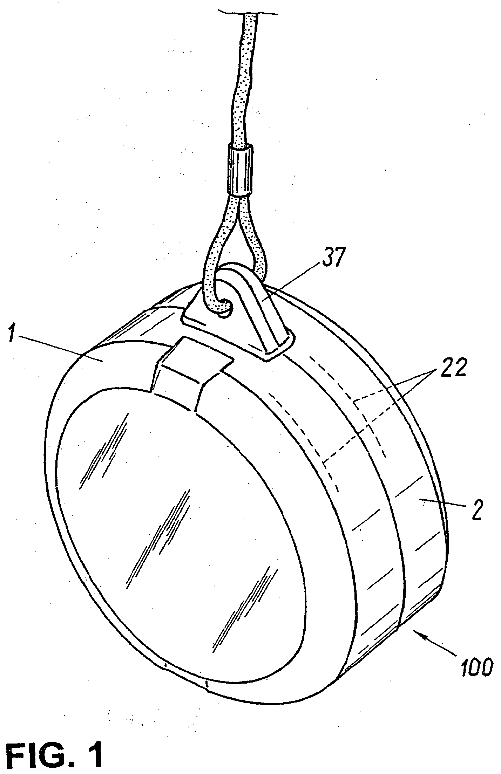

US 4 491 793 A offenbart einen optoelektronischen Kommunikationsport, aufweisend ein tragbares Programmiergerät (vgl. Fig. 1) und einen magnetischen Koppler, welcher als tragbares, längliches, zylindrisches Gehäuse mit Magnetkupplung ausgeführt werden kann. Das Gehäuse ist mit dem Programmiergerät über ein Kabel verbunden und kann magnetisch an einen entsprechenden Adapter an der Zählerwand angedockt werden. Für die Funktion der Kommunikationsvorrichtung ist eine koaxiale Öffnung notwendig, in die ein optisches Messelement, eingeführt und auf eine zweite Öffnung an der Zählerwand gerichtet ist. Die Kommunikationsvorrichtung ist kompliziert und relativ schwer, daher eignet sich nicht zum Tragen in einer Hosentasche oder zum Aufhängen am Schlüsselbund.

Eine ähnliche Bauweise und Nachteile weist ein optoelektronischer Kommunikationsport auf, welcher in US 4 491 792 A dargestellt ist.

In US 2007/059979 A1 ist ein wasserdichtes Kunststoff-Gehäuse mit Unterteil und Deckel gezeigt, welches dazu dient, im Freien verwendbare Antennen oder verschiedene "outdoor equipments" aufzunehmen. Eine Kommunikation außer über die Antenne ist in der Beschreibung nicht genannt.

US 2006/096774 A1 zeigt ein sehr kompliziertes Gehäuse mit einer Dichtung und speziellen Gehäuseteilen, die einen Innenraum umschließen, der eine spezielle Ausrüstung aufnehmen kann. Soweit erkennbar, wird das Gerät auch nicht mitgenommen, sondern mit einer Öse an eine Wand angeschraubt.

DE 100 61 862 A1 stellt eine Mulifunktions-Laborhalterung dar, bei der Magnete mit Membranfederung verwendet werden.

US 2006/256510 A1 beschreibt ein elektronisches Gerät zum Ver- und Entriegeln von Fahrzeugtüren, die einen Schalter auf einer Platine und elastisch wirkenden Kontakt umfasst.

Bei US 2002/070040 A1 handelt es sich um ein Gehäuse für eine GPS-Antenne. Das Gehäuse besteht aus einem wasserbeständigen Material und umhüllt noch ein inneres Gehäuse zum Abschirmen elektromagnetischer Störungen.

US 2007/157457 A1 betrifft eine Vorrichtung zum Testen von Geräten aus dem Bereich Unterhaltungselektronik auf Wasserdichtheit, enthaltend ein Gehäuse mit Deckel.

In EP 1 703 698 A2 ist ein rechteckiges bzw. kastenförmiges Gehäuse eines kabellosen Kommunikationsports gezeigt, das ein Unterteil, eine Deckenwand und eine offene Stirnwand aufweist. Das Gehäuse ist mit Verbindern für den Anschluss an eine Antenne und an eine Platine versehen. Das bekannte Gehäuse ist unhandlich und wegen seiner Bauweise undicht.

Aufgabe der Erfindung ist, ein leichtes, handliches und gegen äußere Einflüsse resistentes Gehäuse eines optoelektronischen Kommunikationsports zu entwickeln. Eine weitere Aufgabe der Erfindung ist, die Ausmaße des Gehäuses derart zu minimalisieren, dass es sich in die Brust- oder Hosentasche der den Kommunikationsport tragenden Person hineinstecken bzw. an einem Schlüsselbund anbringen lässt.

Diese Aufgabe ist durch ein Gehäuse gemäß Anspruch 1 gelöst.

Das Gehäuse kann aus einem wenigstens teilweise permeablen Isolätionsmaterial gefertigt sein, bei dem sich um ein Dielektrikum, wie Glas oder geeignete Kunststoffe, wie Polyester, Polypropylen und insbesondere Polycarbonat handelt.

Vom Vorteil ist, wenn die Materialien, insbesondere Polycarbonat nichtmagnetisch oder nichtmagnetisierbar sind.

Vorzugsweise ist das Material des Gehäuses transparent oder transluzent bzw. gefärbt, wobei die Farbe vorzugsweise an die Farbe anknüpft, die bei anderen Erzeugnissen desselben Herstellers, insbesondere bei den Elektrizitätszählern, Verwendung findet. Der Lichtstrahl kann durch die transparenten Wandungen des Gehäuses durchdringen. Um die Lichtdispersion zu minimieren, sind glatte Oberflächen des Gehäuses vorgesehen.

Das Gehäuse kann in Draufsicht auf seinen Deckel bzw. Unterteil kreisrund oder oval oder polygonal sein. Dabei kann der Deckel bzw. das Unterteil Ausmaße aufweisen, die eine Höhe des Gehäuses wesentlich überschreiten. Vorzugsweise ist das Gehäuse abgeflacht, d. h. es hat die Form, die einer flachen, runden Cremedose ähnelt.

Eine Wasser- und Staubdichtheit des Gehäuses kann durch spezielle Profilierung seiner Ränder, die einen Doppel-Labyrinthverschluss bilden, erzielt werden. So kann das Unterteil oder der Deckel eine Doppel-Seitenwand aufweisen, die eine umlaufende U-förmige Nut bildet, in die der Rand des Gegenstücks hineinpasst. Dabei ist vorteilhaft, dass der Rand des Gegenstücks in seinem Querschnitt geringfügig geneigt oder gefast ist, wodurch innerhalb der U-förmigen Nut beim Schließen des Gehäuses eine Federkraft entsteht, die den Rand etwas verformt und gegen die Nut drückt. Selbstverständlich sind andere technische Mittel möglich, beispielsweise ein umlaufender Wulst, welcher mit einer entsprechenden Auskehlung am Gegenstück mitwirkt, oder zusätzliche elastomere Dichtungen.

Vorteilhaft ist, dass das Gegenstück eine profilierte Seitenwand aufweist, indem im Bereich ihres umlaufenden Randes dünner ausgeführt ist als im übrigen, dickeren Wandbereich, so dass nach dem Schließen des Gehäuses die Außenflächen des Unterteils und des Deckels in Flucht liegen und einen sauberen Abschluß bilden.

Der Konkavspiegel kann durch eine im Material des Deckels geformte Mulde entstanden sein. Die Aufgabe des Konkavspiegels ist, den Lichtstrahl der Optoelektronik zu verstärken. Weiterhin kann der Konkavspiegel und damit der Lichtstrahl seitlich abgeschirmt sein.

Ins Gehäuse kann wenigstens ein Magnetelement eingebaut sein, das vorzugsweise in einer zylindrischen Mulde untergebracht ist, die an einem Boden des Unterteils, auf seiner Unterseite angeordnet ist. Dementsprechend kann die Mulde einen topfförmigen, auf einer Innenseite des Bodens angeordneten Vorsprung bilden.

Die Aufgabe des Magneten ist, einen guten Halt des auf einen Deckel des Elektrizitätszählers gelegten Gehäuses zu gewährleisten.

Eine Positionierung der Platine innerhalb des Gehäuses kann durch nach oben pfostenartig ragende Feststellelemente verwirklicht werden, die vorzugsweise an den topfförmigen Vorsprüngen angeordnet sind. Die Feststellelemente können walzenförmig oder prismatisch, vorzugsweise - in ihrem Querschnitt - kreuzförmig sein. Die Platine kann dementsprechend Öffnungen aufweisen, die zu den Feststellelementen kompatibel sind.

Vorzugsweise weist die Seitenwand des Unterteils in ihrem dickeren Wandbereich Aussparungen auf, in denen jeweils ein vorspringendes Rastelement zur Bildung eines Rast- bzw. Schnappverschlusses angeordnet ist. Das Rastelement rastet in zusammengesetztem Zustand des Gehäuses in eine U-förmige Lasche ein, die an einer äußeren Seitenwand des Deckels angeordnet ist.

Die Platine teilt das Gehäuse in zwei Hohlräume auf, in denen die üblichen Komponenten der Optoelektronik, eine Batterie, ein Mikrokontroller, Dioden und dgl. zu unterbringen sind. Vorzugsweise wird in einen zwischen dem Boden und der Platine liegenden Hohlraum wenigstens eine Batterie platziert.

Weitere Merkmale und Vorteile der Erfindung sind in einem Ausführungsbeispiel anhand der Zeichnung näher erläutert. Die Figuren zeigen:
- Fig. 1: das Gehäuse in zusammengesetztem Zustand, in einer perspektivischen Ansicht;
- Fig. 2: das Gehäuse gemäß Fig. 1 mit einmontierter Platine in einer perspektivischen, explodierenden Darstellung;
- Fig. 3: das Gehäuse gemäß Fig. 2 in Draufsicht auf seinen Deckel;
- Fig. 4: einen axialen Schnitt A-A gemäß Fig. 3;
- Fig. 5: den Deckel in einer perspektivischen Ansicht von oben;
- Fig. 6: den Deckel in einer perspektivischen Ansicht von unten;
- Fig. 7: das Unterteil in einer perspektivischen Ansicht von oben;
- Fig. 8: das Unterteil in einer perspektivischen Ansicht von unten, und
- Fig. 9: das Gehäuse gemäß Fig. 4, jedoch ausgestattet mit Optoelektronik, lösbar angebracht an einer Mulde des Zählers.

Das Gehäuse 100 eines optoelektronischen Kommunikationsports ist aus leicht gefärbtem, jedoch transparentem Polycarbonat gefertigt. Das Polycarbonat zeichnet sich durch eine sehr geringe Temperaturabhängigkeit, eine geringe dielektrische Absorption und einen sehr hohen Isolationswiderstand aus, also durch Eigenschaften, die das Material zum Bau des für die Optoelektronik bestimmten Gehäuses prädistinieren.

Das Gehäuse 100 ist rund, im Wesentlichen axialsymmetrisch und weist eine Form auf, die der Form einer flachen, runden Cremedose sehr ähnlich ist. Wie aus den Figuren 1, 2 und 4 hervorgeht, besteht das Gehäuse 100 aus einem Deckel 1 und einem Unterteil 2. Zur Ausstattung des Gehäuses, in das die Optoelektronik zu unterbringen ist, zählen noch eine schematisch angedeutete Elektronikplatte 3, im Weiteren Platine genannt, und zwei walzenförmige Magnetelemente 4.

Das Gehäuse 100 hat einen Durchmesser von etwa 30 mm und eine Gesamthöhe H = 10 mm, bemessen nach dem Schließen der beiden Teile.

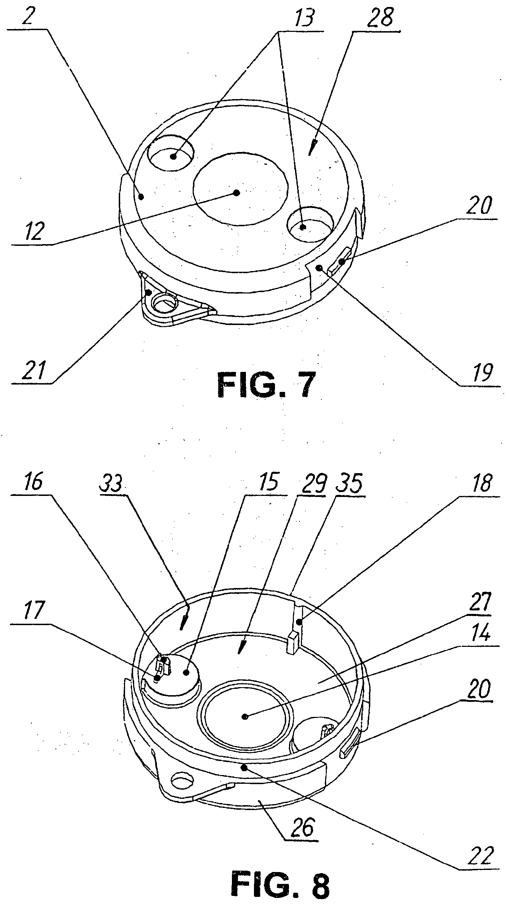

Das Unterteil 2 weist einen Boden 27 auf, an dessen Innenseite 29 und Unterseite 28 zentrisch angeordnet, kreisrunde Vertiefungen 12, 14 liegen. Die Fig. 7 zeigt zwei spiegelsymmetrisch zueinander angeordnete und durch die Vertiefung 12 voneinander beabstandete, ebenfalls kreisförmige Mulden 13 bzw. Sacklöcher zur Aufnahme von Magnetelementen 4.

Die Mulden 13 bilden jeweils einen in Fig. 8 gezeigten, topfförmigen Vorsprung 15, welcher auf der Innenseite 29 des Bodens 27 angeordnet ist.

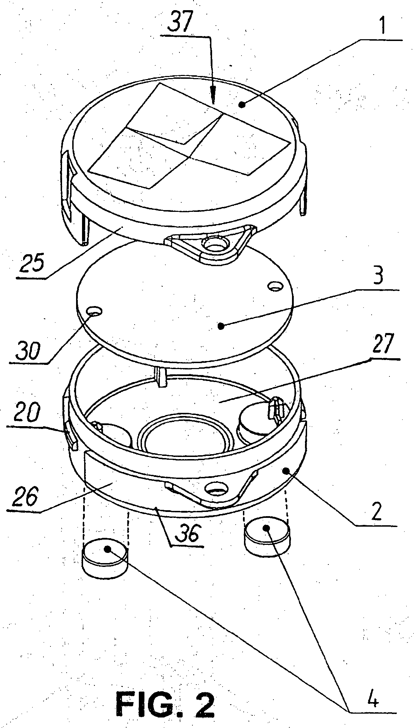

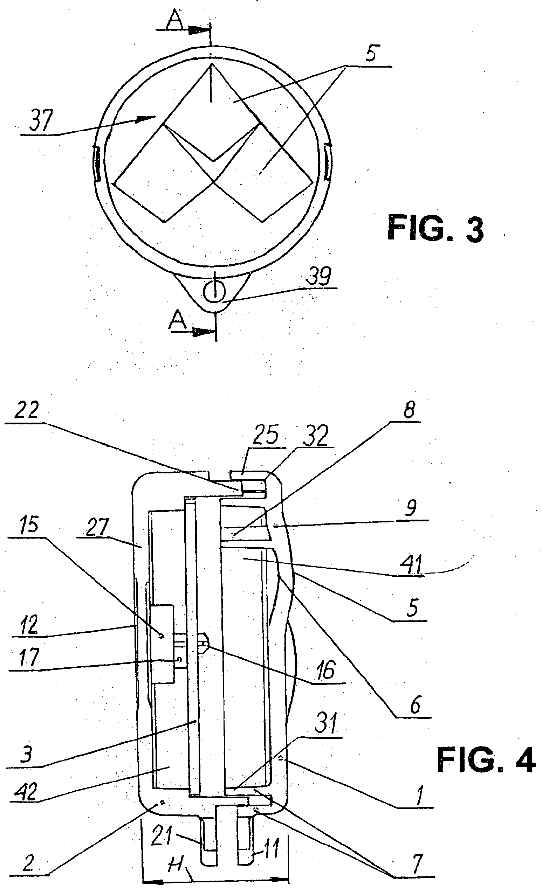

Ferner weist das Unterteil 2 eine Seitenwand 26 auf, an deren inneren Rippen 18 sich die Platine 3 mit ihrem Umfang abstützt. Die Rippe 17 ist an einer Innenseite 33 der Seitenwand 26 angeordnet. Die Platine 3 ist durch zwei kreuzförmige Feststellelemente 16 innerhalb des Unterteils 2 positioniert, die jeweils an einem topfförmigen Vorsprung 15 angebracht sind und nach oben ragen. Wie die Figuren 2 und 8 zeigen, sind die Feststellelemente 16 an ihren freien Enden gefast. Außerdem weisen die Feststellelemente 16 jeweils einen verlängerten Arm 17 auf (vgl. Fig. 4). So können die Feststellelemente 16 durch zwei Öffnungen 30 der Platine 3 durchdringen; im Endzustand ruht die Platine 3 auf den Armen 17.

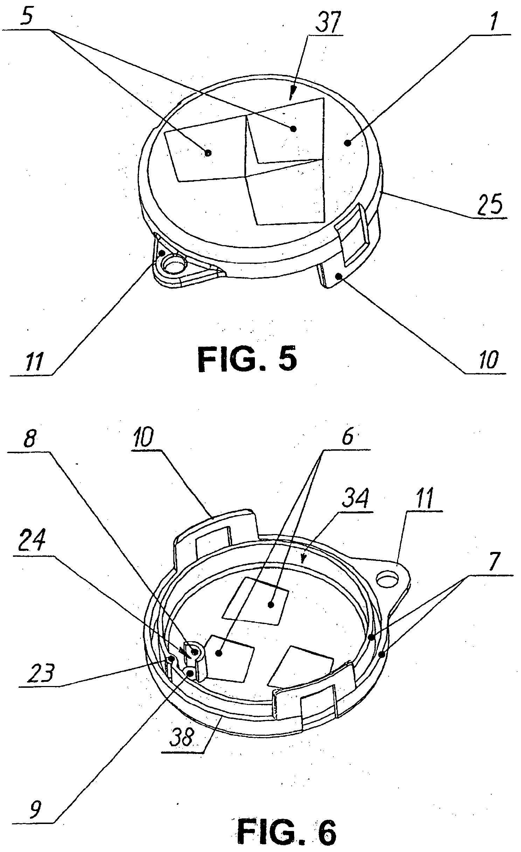

Der Deckel 1 weist eine Doppel-Seitenwand 7 (vgl. Fig. 6) auf, die aus einer äußeren Seitenwand 25 und einer inneren Seitenwand 31 besteht, die eine umlaufende, U-förmige Nut 32 bilden, in die wiederum ein umlaufender Rand 35 der Seitenwand 26 des Unterteils 2 hineinpasst und dort eine formschlüssige Labyrinth-Dichtung 22 bilden, ohne jedoch ein spezielles Dichtungsmaterial verwenden zu müssen. Das Gehäuse 100 ist damit staub- und wasserdicht.

Ferner weist der Deckel 1 einen Konkavspiegel 9 auf, welcher durch eine im Material des Deckels 1 geformte Mulde entstanden ist und der durch durch eine halbzylindrische Innenfläche 24 einer Hülsenhälfte 8 und eine Innenfläche 34 der inneren Seitenwand 31 des Deckels 1 abgeschirmt ist. Die Hülsenhälfte 8 ist fest mit dem Deckel verbunden bzw. an dessen Innenfläche eingeformt.

Wie die Fig. 6 zeigt, ist an der inneren Seitenwand 31 des Deckels 1 eine lokale Krümmung 23 angeformt, die zu der in Fig. 8 gezeigter Rippe 18 kompatibel ist und mit der eine Zentrierung und Zuordnung von Deckel und Gehäuseunterteil erleichtert ist.

Wie der Fig. 8 zu entnehmen ist, ist die Seitenwand 26 des Unterteils 2 im Bereich ihres umlaufenden Randes 35 dünner ausgeführt ist als im übrigen, dickeren, sich an den Boden 27 anschließenden Wandbereich 36. Der dickere Wandbereich 36 ist durch zwei Aussparungen 19 unterbrochen, in denen jeweils ein prismatisches, vorspringendes Rastelement 20 angeordnet ist.

An der äußeren Seitenwand 25 des Deckels 1 sind wiederum zwei U-förmige, über eine Kante 38 der Seitenwand 25 ragende Laschen 10 angeordnet. Die Lasche 10 bilden zusammen mit den Rastelementen 20 einen Rastverschluß des Gehäuses 100.

Am Deckel 1 ist ein Firmenlogo 37 angeordnet, das durch drei deltoidförmige, das Licht verzerrungsfrei hindurchleitende Wölbungen 5 (vgl. Figuren 2, 3 und 5) entstanden ist. Die Wölbungen 5 entsprechen den an der Innenseite des Deckels 1 angeordneten und in Fig. 6 gezeigten, ebenfalls deltoidförmigen Vertiefungen 6. Das Firmenlogo 37 stellt einen stilisierten Buchstaben "A" dar, der in vorliegendem Fall das Firmenlogo der Anmelderin, Firma APATOR ist.

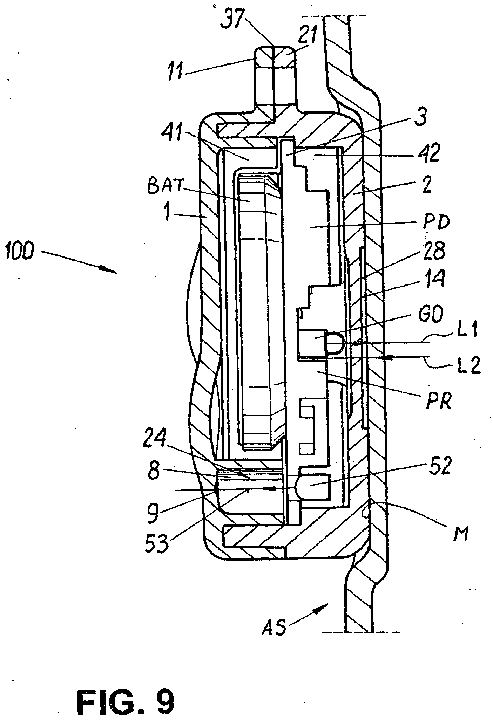

Die Fig. 9 zeigt das Gehäuse 100 in axialem Querschnitt, ähnlich wie bei der Fig. 4, jedoch in zusammengesetztem, verrastetem Zustand. Das Gehäuse 100 beinhaltet, wie schematisch angedeutet, elektronische und optoelektronische Elemente. Das Gehäuse 100 ist durch die Elektronikplatte 3 in zwei Kammern 41, 42 aufgeteilt. In der Kammer 41 ist eine Knopfbatterie BAT untergebracht, während auf der Elektronikplatte 3 sich ein Datenspeicher PD und der Prozessor PR befinden. Weiterhin sind in der Kammer 42 und verbunden mit der Elektronikplatte 3 ein Lesekopf GO und ein LED-Element 52 untergebracht. Der Lesekopf GO ist an der Elektronikplatte 3 montiert und fixiert. Es handelt sich hierbei um einen bidirektional arbeitenden Lesekopf, der sowohl vom Zähler ankommende Strahlung empfangen als auch von der Optoelektronik erzeugte Lichtsignale entsprechend den Lichtstrahlen L1 und L2 (vgl. Fig. 9) senden kann. Dadurch, dass am Gehäuse Magnetelemente 4 eingesetzt sind (vgl. Fig. 2) , kann das Gehäuse, gegebenenfalls mit Optoelektronik, auf einer Außenseite AS eines Zählergehäuses, und zwar in dessen Mulde M (vgl. Fig. 9, rechte Seite) fixiert werden.

Der Konkavspiegel 9 (Linse) trägt zur Sammlung eines durch das LED-Element 52 emittierten Lichtstrahls 53 bei. Das LED-Element 53 befindet sich in der Kammer 42 des Gehäuses. Mit dem Lichtstrahl 53 kann signalisiert werden, dass ein "handshaking", also ein Arbeitskontakt zwischen dem Elektrizitätszähler und mit einer nicht dargestellten Andockstation hergestellt ist.

Am Gehäuse ist eine Öse 39 zum Einhängen am Schlüsselbund, an einer Tafel, am Hosengürtel oder dergleichen vorghesehen. Die Öse 39 setzt sich aus zwei deckungsgleichen Ösenhälften 11, 21 zusammen, welche jeweils an einer entsprechenden Seitenwand des Gehäuses angeformt sind. Das miniaturisierte Gehäuse ist leicht und handlich, lässt sich einfach tragen und in einer Hosentasche bequem verstauen.

**Bezugszeichenliste:**

| | | | |
|---|---|---|---|
| 1. | Deckel | 30. | Öffnung |
| 2. | Unterteil | 31. | Seitenwand |
| 3. | Elektronikplatte (Platine) | 32. | Nut |
| | | 33. | Innenseite |
| 4. | Magnetelement | 34. | Innenfläche (v. 31) |
| 5. | Wölbung | 35. | Rand (v. 26) |
| 6. | Vertiefung | 36. | Wandbereich (v. 26) |
| 7. | Doppel-Seitenwand | 37. | Öse |
| 8. | Hülsenhälfte | 38. | Kante |
| 9. | Konkavspiegel | | |
| 10. | Lasche | | |
| 11. | Ösenhälfte | 41. | Kammer |
| 12. | Vertiefung | 42. | Kammer |
| 13. | Mulde | | |
| 14. | Vertiefung | 52. | LED-Element |
| 15. | Vorsprung | | |
| 16. | Feststellelement | AS. | Außenseite |
| 17. | Arm | BAT. | Batterie |
| 18. | Rippe | GO. | Lesekopf |
| 19. | Aussparung | H. | Höhe |
| 20. | Rastelement | L1. | Lichtstrahl |
| 21. | Ösenhälfte | L2. | Lichtstrahl |
| 22. | Labyrinth-Dichtung | M. | Mulde |
| 23. | Krümmung | PD. | Datenspeicher |
| 24. | Innenfläche | PR. | Prozessor |
| 25. | Seitenwand (v.1) | | |
| 26. | Seitenwand (v.2) | 100. | Gehäuse |
| 27. | Boden | | |
| 28. | Unterseite | | |
| 29. | Innenseite | | |

## Patentansprüche

1. Gehäuse (100) für einen kabellosen, von einer Person mitführbaren optoelektronischen Kommunikationsport, mit einem Unterteil (2) und einem Deckel (1), die die Wand des Gehäuses (100) bilden und über einen staub- und wasserdichten Verschluss (22) miteinander lösbar verrastet sind, wobei die Gehäusewand mit wenigstens einem lichtdurchlässigen Bereich versehen ist, wobei
- der Verschluss ein Doppel-Labyrinthverschluss (22) ist,
- das Gehäuse (100) aus einem wenigstens teilweise lichtpermeablen, dielektrischen Isolationsmaterial gefertigt ist,
- in das Gehäuse wenigstens ein Magnetelement (4) eingebaut ist, das in einer Mulde (13) untergebracht ist, die im Unterteil (2) angeordnet ist,
- und sich im Unterteil (2) ein lichtdurchlässiger Bereich befindet.

2. Gehause nach Anspruch 1, wobei die Mulde (13) einen auf einer Innenseite (29) des Bodens (27) liegenden, topfförmigen Vorsprung (15) bildet, an dem ein pfostenartig ragendes Feststellelement (16) zur Positionierung einer Elektronikplatte (3) angeordnet ist.

3. Gehäuse nach Anspruch 2, wobei zwei Mulden (13) mit Magnetelementen (4) spiegelsymmetrisch zueinander angeordnet sind und durch eine lichtpermeable Vertiefung (12) voneinander beabstandet sind.

4. Gehäuse nach Anspruch 1, wobei das Isolationsmaterial aus Polycarbonat besteht.

5. Gehäuse nach Anspruch 1, wobei der Doppel-Labyrinthverschluss (22) durch einen umlaufenden Rand (35) einer Seitenwand (26) des Unterteils (2) und eine Nut (32) einer Doppel-Seitenwand (7) des Deckels (1) gebildet ist.

6. Gehäuse nach einem der Ansprüche 1 bis 4, wobei das Gehäuse (100) der Form einer flachen, runden Dose, insbesondere Cremedose ähnelt.

7. Gehäuse nach Anspruch 1, wobei im Deckel (1) des Gehäuse (100) wenigstens eine lichtpermeable Linse (9) im Material des Deckels (1) eingeformt ist.

8. Gehäuse nach Anspruch 7, wobei die Linse (9) durch eine halbzylindrische Innenfläche (24) einer Hülsenhälfte (8) an der Innenseite des Deckels (1) und eine Innenfläche (34) der inneren Seitenwand (31) des Deckels (1) seitlich abgeschirmt ist.

9. Gehäuse nach Anspruch 1, wobei die Seitenwand (26) des Unterteils (2) in einem Bereich ihres umlaufenden Randes (35) dünner ausgeführt ist als im übrigen, dickeren, sich an den Boden (27) anschließenden Wandbereich (36).

10. Gehäuse nach Anspruch 9, wobei die Seitenwand (26) des Unterteils (2) in ihrem dickeren Wandbereich (36) Aussparungen (19) aufweist.

11. Gehäuse nach Anspruch 10, wobei an der Aussparung (19) ein vorspringendes Rastelement (20) angeordnet ist, das in zusammengesetztem Zustand des Gehäuses in eine U-förmige Lasche (10) einrastet, die an der äußeren Seitenwand (25) des Deckels (1) angeordnet ist.

12. Gehäuse nach einem der vorhergehenden Ansprüche, wobei das Gehäuse (100) mit einer Öse (37) zum Einhängen am Schlüsselbund, am Hosengürtel oder dergleichen versehen ist.

## Claims

1. Housing (100) for a cable-less, optoelectronic communications port which can be carried by a person, having a lower part (2) and a cover (1) which form the wall of the housing (100) and are detachably latched together via a dust-proof and water-proof closure (22), wherein the housing wall is provided with at least one translucent region, wherein
- the closure is a double labyrinth closure (22),
- the housing (100) is produced from an at least partially light-permeable, dielectric insulation material,
- at least one magnet element (4) is incorporated in the housing and is accommodated in a trough (13) which is arranged in the lower part (2),
- and a translucent region is located in the lower part (2).

2. Housing as claimed in claim 1, wherein the trough (13) forms a pot-shaped protrusion (15) lying on an inner side (29) of the base (27), a post-like protruding fixing element (16) being arranged on the protrusion for positioning an electronics board (3).

3. Housing as claimed in claim 2, wherein two troughs (13) with magnet elements (4) are arranged in a mirror-symmetrical manner with respect to each other and are spaced apart from each other by a light-permeable depression (12).

4. Housing as claimed in claim 1, wherein the insulation material consists of polycarbonate.

5. Housing as claimed in claim 1, wherein the double labyrinth closure (22) is formed by a peripheral edge (35) of a side wall (26) of the lower part (2) and a groove (32) of a double side wall (7) of the cover (1).

6. Housing as claimed in any one of claims 1 to 4, wherein the housing (100) resembles the shape of a flat, round jar, more particularly a cream jar.

7. Housing as claimed in claim 1, wherein in the cover (1) of the housing (100) at least one light-permeable lens (9) is integrally formed in the material of the cover (1).

8. Housing as claimed in claim 7, wherein the lens (9) is laterally shielded by a semicylindrical inner surface (24) of a sleeve half (8) on the inner side of the cover (1) and an inner surface (34) of the inner side wall (31) of the cover (1).

9. Housing as claimed in claim 1, wherein the side wall (26) of the lower part (2) is configured to be thinner in a region of its peripheral edge (35) than in the remaining thicker wall region (36) adjoining the base (27).

10. Housing as claimed in claim 9, wherein the side wall (26) of the lower part (2) has recesses (19) in its thicker wall region (36).

11. Housing as claimed in claim 10, wherein a protruding latching element (20) is arranged on the recess (19) and latches into a U-shaped tab (10) when the housing is assembled, said tab being arranged on the outer side wall (25) of the cover (1).

12. Housing as claimed in any one of the preceding claims, wherein the housing (100) is provided with an eyelet (37) for hanging on a keyring, belt or the like.

## Revendications

1. Boîtier (100) pour un port de communication optoélectronique portatif sans fil, comprenant une base (2) et un couvercle (1) qui forment l'enceinte du boîtier (100) et sont joints, amovibles, par encliquetage d'un dispositif de verrouillage (22) étanche à l'eau et aux poussières, boîtier dans lequel ladite enceinte est dotée d'au moins un secteur transparent, tandis que le dispositif de verrouillage est une fermeture à double labyrinthe (22), que le boîtier (100) est réalisé en un matériau isolant diélectrique au moins partiellement transparent, que le boîtier inclut au moins un élément magnétique (4) logé dans une cavité (13) ménagée dans la base (2) et que ladite base (2) comprend un secteur transparent.

2. Boîtier selon la revendication 1, dans lequel la cavité (13) constitue, sur un côté intérieur (29) du fond (27), un élément saillant (15) en forme de pot sur lequel est agencée une butée (16) de type ergot pour le positionnement d'une platine électronique (3).

3. Boîtier selon la revendication 2, dans lequel deux cavités (13) comportant des éléments magnétiques (4) sont disposées en symétrie miroir l'une par rapport à l'autre et espacées entre elles par un creux (12) transparent.

4. Boîtier selon la revendication 1, dans lequel le matériau isolant est du polycarbonate.

5. Boîtier selon la revendication 1, dans lequel la fermeture à double labyrinthe (22) est constituée par un bord périphérique (35) d'une paroi latérale (26) de la base (2) et par une gorge (32) agencée dans une paroi double (7) du couvercle (1).

6. Boîtier selon l'une quelconque des revendications 1 à 4, dans lequel le boîtier (100) a une forme similaire à celle d'une boîte ronde et plate, en particulier d'une boîte à crème.

7. Boîtier selon la revendication 1, dans lequel au moins une lentille transparente (9) est incorporée par moulage dans le matériau du couvercle (1).

8. Boîtier selon la revendication 7, dans lequel la lentille (9) est isolée latéralement par une surface intérieure (24) semi-cylindrique d'un demi-tube (8) agencé sous la face intérieure du couvercle (1) et par une surface intérieure (34) de la paroi latérale intérieure (31) dudit couvercle (1).

9. Boîtier selon la revendication 1, dans lequel la paroi latérale (26) de la base (2) est, dans un secteur (35) de son bord périphérique, plus fine que dans le secteur restant (36) plus épais de la paroi, adjacent au fond (27).

10. Boîtier selon la revendication 9, dans lequel des évidements (19) sont ménagés dans le secteur (36) plus épais de la paroi latérale (26) de la base (2) dudit boîtier.

11. Boîtier selon la revendication 10, dans lequel il est agencé, dans l'évidement (19), un élément saillant d'encliquetage (20) qui, à l'état assemblé du boîtier, s'enclenche dans une languette (10) en U disposée sur la face extérieure de la paroi latérale (25) du couvercle (1).

12. Boîtier selon l'une quelconque des revendications précédentes, dans lequel le boîtier (100) est doté d'un oeillet (37) permettant d'accrocher ledit boîtier à un trousseau à clés, à une ceinture de pantalon ou similaire.
